# EUROPEAN PATENT APPLICATION

(11) **EP 4 640 772 A1**
(43) Date of publication of application: **29.10.2025**
(21) Application number: 24171774.3
(22) Date of filing: 23.04.2024
(51) Int. Cl.: C09D 11/101, C09D 11/104, C09D 11/30, H05K 1/00, H05K 3/28

(54) **A CURABLE INKJET COMPOSITION FOR THE MANUFACTURING OF PRINTED CIRCUIT BOARDS**

(71) Applicant: AGFA-GEVAERT NV, 2640 Mortsel (BE)
(72) Inventor: VAN AERT, Hubertus, 2640 Mortsel (BE); MATTHYS, Mitch, 2640 Mortsel (BE)
(74) Representative: Viaene, Kris

(57) **Abstract**

A curable inkjet composition for a printed circuit board comprising one or more photopolymerizable compounds, a photoinitiator, and a polyester comprising dimerized fatty acids, wherein the amount of polyester is more than 2.5 wt% relative to the total weight of the inkjet ink composition.

## Description

### Technical Field

The present invention relates to a curable inkjet composition for the manufacturing of printed circuit boards. The invention also relates to a method for manufacturing a printed circuit board.

### Background Art

Printed Circuit Boards (PCBs) are traditionally manufactured in an extensive process including multiple photolithographic and etching steps, thereby generating a lot of waste. In order to reduce the amount of process steps, production costs, and waste, there is an increased interest in digitalizing the PCB manufacturing workflow.

Inkjet printing is a preferred digital manufacturing technology for several PCB production steps, such as the application of the etch resist and the solder mask, or printing of the legend.

The PCB solder mask, or solder resist, acts as an insulator between the copper traces, and prevents the formation of solder bridges. Moreover, it plays an important role in protecting the board against oxidation triggered by outer influences, such as weather conditions, temperature variations, and humidity. When mechanical defects occur in the solder mask due to exposure to these external conditions, the protective and insulating function of the solder mask can be negatively affected. Therefore, the main objective for producing an effective solder mask is to provide a good resistance against the conditions to which it is exposed.

During the production of a PCB solder mask using inkjet, it is often a problem that cracks appear in the solder mask. This is a result of thermal stress occurring while soldering electronic components on the PCB, or due to heat variations during the lifetime of the PCB. Because of this, the printed and cured solder mask needs to resist several thermal stress tests, such as IR reflow resistance.

EP-A 3778793 (Taiyo ink Manufacturing) discloses an inkjet ink for solder mask printing, comprising a photopolymerizable monomer with a cyclic skeleton and a shrinkage of less than 10%, which results in an improved thermal resistance.

EP-A 1624001 (Taiyo Ink Manufacturing) discloses an inkjet ink for solder mask printing comprising a (meth)acrylate monomer including a thermosetting functional group. WO2020/109769 (Electra Polymers) discloses an inkjet ink for solder mask printing comprising a reactive monomer, an oligomer of prepolymer containing at least one epoxy or oxetane functional group, a free radical polymerizable compound, a thermal cross-linking agent and a radical initiator.

EP-A 4215551 (Konika Minolta) discloses an inkjet ink for solder mask printing containing a (meth)acrylic monomer, a photopolymerization initiator, a thermosetting compound, and a gelling agent. This ink is improving adhesiveness and heat resistance and has a low relative dielectric constant.

JP2022137834 (JNC Corp) discloses a photocurable composition suitable for use in the production of electronic circuit boards, comprising a compound (D) having a structural unit derived from a dimer acid and having a (meth)acryloyl end group. The cured composition exhibits good adhesiveness to an inorganic substrate, low warpage, and good ion migration resistance.

However, there is still a need for inkjet inks for use in a PCB manufacturing process that have an improved resistance to thermal stress.

### Summary of invention

It is an object of the invention to provide a curable inkjet composition for solder mask printing in the manufacturing of printed circuit boards (PCBs) having an improved resistance to thermal stress.

The object of the invention is realized by the curable inkjet composition as defined in claim 1.

Further objects of the invention will become apparent from the description hereinafter.

### Description of embodiments

### Definitions

The term "monofunctional" in e.g. monofunctional polymerizable compound means that the polymerizable compound includes one polymerizable group.

The term "difunctional" in e.g. difunctional polymerizable compound means that the polymerizable compound includes two polymerizable groups.

The term "polyfunctional" or "multifunctional" in e.g. polyfunctional polymerizable compound means that the polymerizable compound includes more than two polymerizable groups.

The term "alkyl" means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless otherwise specified a substituted or unsubstituted alkyl group is preferably a C₁ to C₆-alkyl group.

Unless otherwise specified a substituted or unsubstituted alkenyl group is preferably a C₂ to C₆-alkenyl group.

Unless otherwise specified a substituted or unsubstituted alkynyl group is preferably a C₂ to C₆-alkynyl group.

Unless otherwise specified a substituted or unsubstituted alkaryl group is preferably a phenyl or naphthyl group including one, two, three or more C₁ to C₆-alkyl groups.

Unless otherwise specified a substituted or unsubstituted aralkyl group is preferably a C₇ to C₂₀-alkyl group including a phenyl group or naphthyl group.

Unless otherwise specified a substituted or unsubstituted aryl group is preferably a phenyl group or naphthyl group

Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, amine, ether, thioether, ketone, aldehyde, sulfoxide, sulfone, sulfonate ester, sulphonamide, -Cl, -Br, -I, -OH, -SH, -CN and -NO₂.

Unless otherwise specified an alkyl, a cycloalkyl or an aryl interrupted by a heteroatom means that a heteroatom in present in the carbon chain of said group, for example -C-O-C-C- or -C-S-C-C-.

### Curable inkjet composition

The curable inkjet composition according to the present invention comprises one or more photopolymerizable compounds, a photoinitiator, and a polyester comprising fatty acid dimer units, wherein the amount of polyester is more than 2.5 wt% relative to the total weight of the inkjet ink composition.

The composition is a radiation-curable composition. Any type of radiation may be applied, but preferred radiation types are UV-light and UV-LED light. Therefore, the curable composition according to the present invention is preferably a UV-curable composition.

In a preferred embodiment, the composition according to the present invention comprises a mixture of UV-curable compounds and thermal cross-linking agents. Therefore, the curable composition according to the present invention is preferably also a thermally curable composition. Any type of heat source may be used for the thermal curing step, but preferably the thermal curing is performed in an oven. The two curing processes, thermal and UV, can take place simultaneously or sequentially.

The curable inkjet composition according to the invention is preferably applied as an inkjet ink.

For reliable industrial inkjet printing, the viscosity of the curable inkjet ink is preferably no more than 20 mPa.s at 45 °C, more preferably from 1 to 18 mPa.s at 45 °C, and most preferably from 5 to 15 mPa.s at 45 °C, all at a shear rate of 1000 s⁻¹.

A preferred jetting temperature is from 10 to 70 °C, more preferably from 20 to 55 °C, and most preferably from 25 to 50 °C. For good image quality and adhesion, the surface tension of the curable inkjet ink is preferably from 18 to 70 mN/m at 25 °C, more preferably from 20 to 40 mN/m at 25 °C.

### Polyester comprising fatty acid dimer units

The curable inkjet composition according to the present invention comprises a polyester comprising fatty acid dimer units. The polyester is preferably a polyester copolymer comprising at least:
- one monomeric unit A, which is a dimer fatty residue selected from a dimer fatty diacid residue and a dimer fatty diol residue; and
- one monomeric unit B, which is a residue of a linear or branched C2 to C32 dicarboxylic acid or diol.

The term "dimer fatty acid" (also referred to as dimer fatty diacid or fatty acid dimer) is well known in the art and refers to the dimerization of mono- or polyunsaturated fatty acids and/or esters thereof. Dimer fatty acids are described in T.E. Bruere, 'Dimer Acids" in J.I. Kroschwitz (ed.), Kirk-Othmer Encyclopedia of Chemical Technology, 4th Ed., Wily, New York, 1993, Vol 8. Page 223-237. They are prepared by polymerizing fatty acids under pressure and then removing most of the unreacted fatty acid starting materials by distillation. The final product usually contains some small amounts of mono fatty acid and/or trimer fatty acids but is mostly made up of dimer fatty acids.

The amount of the polyester comprising fatty acid dimers in the curable inkjet composition must be more than 2.5 wt%, preferably at least 5 wt%, relative to the total weight of the inkjet composition. Preferably, the amount of the polyester comprising fatty acid dimers in the curable inkjet composition is less than 15 wt% relative to the total weight of the inkjet composition, even more preferred less than 10 wt%. Above 15 wt%, the inkjet composition may become too viscous.

Monomeric unit A is a dimer fatty residue selected from a dimer fatty diacid residue and a dimer fatty diol residue. The dimer fatty diacids or dimer fatty diols are preferably resulting from the dimerization of C2 to C36 fatty acids, more preferably C12 to C24 fatty acids, even more preferably C16 to C20 fatty acids and most preferably C18 fatty acids. Thus, the resulting dimer fatty diacid preferably comprises 4-72 carbon atoms, more preferably 24 - 48, even more preferably 32 - 40 and especially preferred 36 carbon atoms. Dimerized C18 fatty acids can have one or more unsaturated bonds, e.g. C18:1 = oleic acid, C18:2 = linoleic acid, C18:3 = linolenic acid. Preferably, the fatty acids used to prepare dimer fatty diacids are linear monounsaturated fatty acids, e.g. myristoleic acid (14:1(9)), palmitoleic acid (16:1(9)), sapienic acid (16:1(6)), oleic acid (18:1(9)), elaidic acid (18:1 (9t)), and vaccenic acid (18:1(11t)). One can also prepare dimer fatty acids using fatty acids having more than one unsaturated bond, e.g. linoleic acid = CH3(CH2)4CH=CHCH2CH=CH(CH2)7COOH (ie. 18:2(9,12)) or α-linolenic acid = CH3CH2CH=CHCH2CH=CHCH2CH=CH(CH2)7COOH (ie. 18:3(9,12,15)). The resulting fatty acid dimers can still contain unsaturated bonds.

The fatty acid dimers may be hydrogenated or non-hydrogenated. A hydrogenated fatty acid dimer residue may have better oxidative or thermal stability which is desirable in UV curable PCB solder mask inks.

Preferred fatty acid dimers are dimerization products of oleic acid, linoleic acid, linolenic acid, palmitoleic acid or elaidic acid. Most preferably, the fatty acid dimers are derived from oleic acid. The fatty acid dimers may also be dimerization products of mixtures of unsaturated fatty acids obtained from the hydrolysis of natural fats and oils, e.g. sunflower oil, soybean oil, olive oil, rapeseed oil, cottonseed oil or tall oil. The molecular weight (weight average) of the fatty acid dimer is preferably in the range from 450 to 690, more preferably 500 to 640, particularly 530 to 610, and especially 550 to 590.

Polyester copolymers comprising fatty acid dimer units can be prepared from the fatty acid dimer itself or alternatively, the fatty acid dimer may be converted into a dimer fatty diol (also referred to as fatty diol dimer). A fatty diol dimer may have similar properties compared to a fatty acid dimer, except that the acid groups in the fatty acid dimer are replaced with hydroxyl groups in the fatty diol dimer. The fatty diol dimer may be hydrogenated or non-hydrogenated.

Monomeric unit B is a residue of a linear or branched C2 to C32 dicarboxylic acid or diol. Examples of monomers that can be implemented as monomeric units B are aromatic dicarboxylic acids such as phthalic acid, isophthalic acid, terephthalic acid or aliphatic dicarboxylic acids such as adipic acid, glutaric acid, succinic acid, pimelic acid, suberic acid, azelaic acid, sebacic acid, furan dicarboxylic acid, heptane dicarboxylic acid, octane dicarboxylic acid, nonane dicarboxylic acid, decane dicarboxylic acid, undecane dicarboxylic acid and dodecane dicarboxylic acid. Adipic acid and succinic acid are particularly preferred. Further examples of monomers that can be implemented as monomer units B are diols such as neopentyl glycol, ethylene glycol, 1,3-propane diol, 2,3-butane diol, 1,3-butane diol, 1,6 hexane diol, 1,4-butane diol, 3-metyyl pentane glycol, 1,2-propane diol, cyclohexane dimethanol, di (hydroxymethyl) tetrahydrofuran, trimethylpropane mono(meth)allyl ether, pentaerythritol mono(meth)allyl ether, dipentaerythriol, sorbitol, glycerol and diglycerol. Preferred diols are neopentyl glycol, trimethylol propane and pentaerythritol. Examples of hydroxy functional carboxylic acids are, without being limited thereto, hydroxy butyric acid, lactic acid, and hydroxy hexanoic acid.

Instead of dicarboxylic acids, anhydrides can also be used, e.g. phthalic anhydride instead of phthalic acid or succinic anhydride instead of succinic acid. Instead of hydroxy functional carboxylic acids, also cyclic esters can be used, such as lactones.

The polyester comprising fatty acid dimers preferably has a molecular weight (number average) of more than 1000 g/mol, more preferably of more than 2000 g/mol, in which the number average molecular weight is determined by end group analysis. The number average molecular weight of the polyesters can for example be determined via end group analysis with reference to the hydroxyl value. The hydroxyl value is defined as the number of mg of potassium hydroxide equivalent to the hydroxyl content of 1g of sample and can be measured by acetylation followed by hydrolysation of excess acetic anhydride. The acetic acid formed can then be titrated with an ethanolic potassium hydroxide solution. Another way of determining number average molecular weight via end group analysis is 1H NMR spectroscopy. When the molecular weight of the polyester is lower than 1000 g/mol, the curable inkjet composition may not have sufficient IR reflow resistance because the lower molecular weight polyesters will not have sufficient polymer chain entanglements which are believed to contribute to the improved thermal performance.

The polyester comprising fatty acid dimers preferably is a linear polyester having an end group functionality of 2. A higher functionality means that the polyesters are branched or star-shaped, which possibly results in less polymer chain entanglements for the same molecular weight. Consequently, for polyesters having a functionality of more than 2, a higher molecular weight would be desirable to obtain sufficient chain entanglements. However, a too high molecular weight could negatively affect the viscosity of the curable inkjet composition.

Preferably, the polyester comprising fatty acid dimer units are polyester copolymers having hydroxyl end groups, referred to as polyester polyols. Synthesis methods to prepare such polyester polyols are given in WO2015/097433. Preferred polyester polyols comprise monomeric units based on a C36 fatty acid dimer, adipic acid and neopentyl glycol. Examples of suitable polyester polyols are: Priplast 3190, Priplast 3197, Priplast 1837, Priplast 1838 and Priplast 3238, supplied by Cargill (formerly Croda).

The polyester comprising fatty acid dimer units may also comprise at least two functional groups selected from, acrylate, methacrylate, vinyl, (meth)acrylamide, epoxy, lactone, aziridine, carboxylic acid, methyl esters, or other reactive esters or end groups comprising blocked or free isocyanato groups. In a preferred embodiment, the polyester comprises at least one UV-reactive end group. Without being limited thereto, examples of polyesters comprising fatty acid dimer units and UV reactive end groups are B Tough UV20 supplied by Cargill (formerly Croda), PEAM-1044 and PEAM-1769 supplied by Designer Molecules Inc.

The synthesis of polyester comprising fatty acid dimer units comprising acrylate or methacrylate functional groups can e.g. be accomplished via 2 methods: First, by using a hydroxyl, carboxylic or anhydride monomer or cyclic ester monomer directly in the polyester synthesis (e.g. hydroxyethyl acylate or hydroxy ethyl methacrylate); second, by a post polymerisation modification of a polyester polyol. The polyester polyol can e.g. be modified using acrylic acid anhydride, acryloyl chloride, isocyanato propyl (meth)acrylate, or glycidyl (meth)acrylate.

Other examples of methods for post-modification of fatty-acid dimer containing polyester polyols are disclosed in WO 2022/200400 and WO 2022/200415.

### Photopolymerizable compounds

The curable inkjet composition according to the present invention comprises one or more photopolymerizable compounds.

Photopolymerizable compounds are preferably free radical polymerizable compounds. The free radical polymerizable compounds may be monomers, oligomers and/or prepolymers. These monomers, oligomers and/or prepolymers may possess different degrees of functionality, i.e. a different amount of free radical polymerizable groups. A mixture including combinations of mono-, di-, tri- and higher functional monomers, oligomers and/or prepolymers may be used. The viscosity of the curable inkjet ink may be adjusted by varying the ratio between the monomers and oligomers.

The photopolymerizable compounds may also comprise functional groups, such as thiols, hydroxyls, amines, sulfonic acids, phosphoric acids, and carboxylic acids. Examples of hydroxyl-functionalized polymerizable compounds are those listed in paragraphs [0028] to [0029] in US2015/0090482A.

Preferred photopolymerizable compounds are those listed in paragraphs [0106] to [0115] in EP-A 1911814.

Especially preferred photopolymerizable compounds are selected from the group consisting of 2-ethylhexyl acrylate, lauryl acrylate, stearyl acrylate, 3,3,5-trimethylcyclohexyl acrylate, isobornyl acrylate, hexanediol diacrylate, trimethylolpropane triacrylate, polyethyleneglycol diacrylate, 2-phenoxyethyl acrylate, n-butyl (meth)acrylate, and 4-hydroxybutyl (meth)acrylate, 2-ethylhexyl methacrylate, lauryl methacrylate, stearyl methacrylate, 3,3,5-trimethylcyclohexyl methacrylate, isobornyl methacrylate, 1,6-hexanediol dimethacrylate, trimethylolpropane trimethacrylate, polyethyleneglycol dimethacrylate and acryloyl morpholine.

An especially preferred photopolymerizable compound is 4-tert-butylcyclohexylacrylate. Using this monomer may positively affect the mechanical properties of the solder mask, because the cured polymer of 4-tert-butylcyclohexylacrylate has a relatively high Tg. Furthermore, the bulky tert-butylcycohexyl group may contribute to a cured polymer film having less shrinkage. Due to the low viscosity and the low volatility of this monomer, the properties of the curable composition may be further tuned to make it suitable for inkjet printing without compromising other properties. When 4-tert-butylcyclohexylacrylate is being used in the composition, it is preferably present in an amount from 1 to 40 wt%, preferably from 2.5 to 30 wt%, and most preferably from 5 to 20 wt% based on the total weight of the curable inkjet composition.

The curable inkjet composition preferably comprises a photopolymerizable compound containing a vinyl group. More preferably, the vinyl group is a vinylether group, an N-vinyl amide group or an N-vinyl carbamate group.

Preferred examples of photopolymerizable compounds containing a vinylether group or an N-vinylamide group are those listed in paragraphs [0047] to [0056] in EP-A 3686251.

A particularly preferred vinylether containing photopolymerizable compound is 2-(2-vinyloxyethoxy)ethyl acrylate, as it is advantageous in providing a good balance between the curability and the viscosity of the curable inkjet composition, especially when it is used in an amount of 5 wt%, preferably at least 7.5 wt% and most preferably at least 10 wt% based on the total weight of the curable inkjet composition.

Particularly preferred vinylamide containing photopolymerizable compounds are N-vinyl-2-pyrrolidone and N-vinylcaprolactam as they combine a high Tg with a good ink curability and a good adhesion of a cured ink layer to a recording medium.

A photopolymerizable compound containing an N-vinyl carbamate group is preferably a cyclic compound represented by General Formula I, 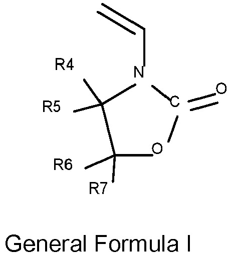 wherein R4, R5, R6 and R7 independently from each other represent hydrogen, alkyl, cycloalkyl, or aryl and combinations thereof, any of which may be interrupted by heteroatoms. Any of R4 to R7 may represent the necessary atoms for forming a five-or six-membered ring.

Preferably R4, R5, R6 and R7 independently from each other represent hydrogen or a substituted or unsubstituted C₁ to C₁₀ alkyl group.

Preferred compounds are disclosed in WO 2015/022228 (BASF) and US 4831153 (DOW CHEMICAL).

Cyclic compounds according to General Formula I are often referred to as oxazolidinones. A particularly preferred oxazolidinone is N-vinyl-5-methyl-2-oxazolidinone, also referred to as vinyl methyl oxazolidinone, or VMOX. Including VMOX improves the hardness of the cured ink layer, especially when it is used in an amount from 1 to 50 wt%, preferably from 2.5 to 40 wt%, and most preferably from 5 to 30 wt% based on the total weight of the curable inkjet composition. Moreover, VMOX has a low viscosity compared to other N-vinyl compounds, which makes it especially suitable for ink jet printing.

The photopolymerizable compound including a vinylether, an N-vinylamide or an N-vinyl carbamate may be used singly or in a combination of one or more polymerizable compounds including a vinylether, an N-vinylamide or an N-vinyl carbamate.

Preferably, the curable inkjet composition further comprises a photopolymerizable compound comprising a tricyclic aliphatic group. A tricyclic aliphatic group is characterized in that three aliphatic rings together form a fused ring system, a bridged ring system, or a bridged fused ring system.
- In a fused ring system, at least two rings share two adjacent atoms. In other words, the rings share one covalent bond.
- In a bridged ring system, at least two rings share three or more atoms, separating the bridgehead atoms by a bridge containing at least one atom.
- Finally, a bridged fused ring system is a ring system where at least two of the rings constitute a fused ring system and the remaining rings are created by one or more bridges.

In the case of a tricyclic aliphatic group, there are always 2 ring junctions, which may be both fused, both bridged, or a combination of fused and bridged.

A photopolymerizable compound comprising a tricyclic aliphatic group is less flexible and has a higher structural rigidity because the atoms being part of the ring system are hindered in their movement by being joint to other rings, compared to conventional photopolymerizable compounds used in curable inkjet compositions for a printed circuit board. Next to this, a tricyclic aliphatic group is also considered a 'bulky' group, meaning that they are possibly affecting the structure of the cured polymer network by controlling polymer chain length and by creating distance in the polymer network. These properties are all believed to contribute to the thermal properties of the cured ink when a photopolymerizable compound comprising a tricyclic aliphatic group is used instead of other conventional photopolymerizable compounds.

Without being limited thereto, examples of photopolymerizable compounds comprising a tricyclic aliphatic group are tricyclodecanedimethanol diacrylate (CAS registry number 42594-17-2), dicyclopentanyl acrylate (CAS registry number: 7398-56-3), tricylodecanedimethanol dimethacrylate (CAS registry number 43048-08-4), tricyclodecanemethanol acrylate (CAS registry number 93962-84-6), dihydrodicyclopentadienyl acrylate (CAS registry number 903574-98-1), adamantyl (meth)acrylate, (Octahydro-4,7-methano-1H-inden-5-yl)methyl 2-methyl-2-propenoate (CAS registry number 127823-23-8), (Octahydro-4,7-methano-1H-inden-5-yl)methyl 2-propenoate (CAS registry number 127823-21-6), tricyclodecyl methacrylate or dicyclopentyl methacrylate (CAS registry number 34759-34-7), dicyclopentanyloxyethyl acrylate (CAS registry number 99353-06-7), 2-propenoic acid, (octahydro-4,7-methano-1H -indene-2,5-diyl)bis(methylene) ester (CAS registry number 116738-40-0), CAS registry number 30305-68-1, adamantyl methacrylate (CAS registry number 16887-36-8), adamantyl acrylate (CAS registry number 129090-25-1), 2-propenoic acid, octahydro-4,7-methano-1H-indenyl ester (CAS registry number 79637-74-4), dihydrodicyclopentadienyl methacrylate (CAS registry number 31621-69-9), dicyclopentenyloxyethyl acrylate (CAS registry number 68169-12-0, dicyclopentenyloxyethyl methacrylate (CAS registry number: 68169-03-9), 2-propenoic acid, 2-methyl-, 2-[(3a,4,5,6,7,7a-hexahydro-4,7-methano-1H-inden-5-yl)oxy]ethyl ester (CAS registry number 75662-22-5), 3-hydroxy-1-adamantyl methacrylate (CAS registry number 115372-36-6), 2-isopropyl-2-adamantyl methacrylate (CAS registry number 297156-50-4), 2-methyl-2-adamantyl methacrylate (CAS registry number 177080-67-0), 2-ethyl-2-adamantyl methacrylate (CAS registry number 209982-56-9), 3,5-dihydroxyadamantan-1-yl methacrylate (CAS registry number 115522-15-1), dicyclopentenyloxyethyl acrylate (CAS registry number 65983-31-5) or a combination thereof.

Preferred types of tricyclic aliphatic groups are tricyclodecane and tricyclodecene groups, and preferred photopolymerizable compounds comprising a tricyclodecane or a tricyclodecene group are tricyclodecanedimethanol di(meth)acrylate, tricyclodecanemethanol (meth)acrylate, dicyclopentanyl (meth)acrylate, and dihydrodicyclopentadienyl (meth)acrylate.

### Thermal cross-linking agent

The curable composition of the present invention preferably comprises one or more thermal cross-linking agent selected from the group consisting of unblocked isocyanates, blocked isocyanates and triazine compounds. The presence of a thermal cross-linking agent may improve the adhesion after soldering or ENIG plating and the ENIG resistance of the obtained coating. The thermal cross-linking agent may be monofunctional, difunctional or multifunctional.

The inkjet composition may comprise a mixture of different thermal cross-linking agents.

Preferred thermal cross-linking agents are oxiranes, oxetanes, melamine-formaldehyde resins, urea-formaldehyde resins, benzoguanamine-formaldehyde resins, cyclic carbonate compounds, carbodiimides, isocyanates, blocked isocyanates, and combinations thereof.

Preferred thermal cross-linking agents are isocyanate compounds. Isocyanate compounds are preferably used in combination with a compound comprising active hydrogen functionalities, including, without limitation, alcohols, thiols, amines, water, or combinations thereof. Atmospheric moisture may also cause isocyanate cross-linking. When atmospheric moisture is reacting with an isocyanate, it may not be necessary to prepare an ink combining the isocyanate compound with a compound comprising active hydrogen functionalities.

The isocyanate compound may be an aliphatic, an alicyclic or an aromatic isocyanate. In case the isocyanate compound is a multifunctional isocyanate, it may comprise a combination of aliphatic, alicyclic or aromatic isocyanate functionalities.

Examples of aliphatic isocyanates include, without limitation, 1,6-hexamethylene diisocyanate (HDI or HMDI), isophorone diisocyanate (IPDI), 1,3-(isocyanatomethyl)cyclohexane (hydrogenated XDI), lysine diisocyanate (LDI), 2,2,4-trimethyl hexamethylene diisocyanate (TMDI), and dimeryl diisocyanate (DDI).

Examples of alicyclic isocyanates include, without limitation, isophorone diisocyanate (IPDI), methylcyclohexane 2,4-(2,6)-diisocyanate (hydrogenated TDI), and 4,4'-methylenebis(cyclohexylisocyanate) (hydrogenated MDI).

Examples of aromatic isocyanates include, without limitation, toluene diisocyanate (TDI), 1,5-naphthalene diisocyanate (NDI), 4,4'-di-phenyl-methanediisocyanate (MDI) and xylylene diisocyanate (XDI).

Examples also include adducts (e.g. trimethylol propane adducts), uretdiones, biurets, and isocyanurates of the isocyanates listed above.

The isocyanate compound may be blocked or unblocked, preferably blocked.

A blocked isocyanate can be obtained by reacting an isocyanate with a blocking agent of choice. Such a blocking agent is a protective group, which is cleaved off at elevated temperatures, for example during a thermal curing process. The blocking agent can be chosen such that it will cleave off at a certain temperature, the so-called de-blocking temperature. Using a blocked isocyanate typically improves the storage stability of the inkjet ink.

Examples of the blocking agent include alcohols such as ethanol, n-propanol, isopropanol, t-butanol, and isobutanol; phenols such as phenol, chlorophenol, cresol, xylenol, and p-nitrophenol; alkylphenols such as p-t-butylphenol, p-sec-butylphenol, p-sec-amylphenol, p-octylphenol, and p-nonylphenol; basic nitrogen-containing compounds such as 3-hydroxypyridine, S-hydroxyquinoline, and 8-hydroxyquinaldine; active methylene compounds such as diethyl malonate, ethyl acetoacetate, and acetylacetone; acid amides such as acetamide, acrylamide, and acetanilide; acid imides such as succinimide and maleic imide; imidazoles such as 2-ethylimidazole and 2-ethyl-4- methylimidazole; pyrazoles such as pyrazole, 3-methylpyrazole, and 3,5-dimethylpyrazole; lactams such as 2-pyrrolidone and 8-caprolactam; oximes of ketone or aldehyde, such as acetoxime, methyl ethyl ketone oxime, cyclohexanone oxime, and acetaldoxime; ethyleneimine; and bisulfite.

Hindered secondary amines may be used as blocking agents for toxicology reasons. Preferred hindered secondary amines are selected form the group consisting of ethyl-tert-butyl amine, diisopropyl amine, 2,6-dimethyl-piperidine, ethyl-isopropyl amine, di-tert-butyl amine and diisobutyl amine.

A preferred blocked isocyanate compound is a blocked HDI oligomer or a blocked IPDI oligomer. Such an oligomer can be for example a trimethylol propane adduct, a biuret, or an isocyanurate.

Particularly preferred blocked isocyanate compounds are Trixene BI 7960, a HDI biuret blocked with 3,5-dimethylpyrazole, commercially available from Lanxess and Trixene BI7982, a HDI trimer blocked with 3,5-dimethylpyrazole, commercially available from Lanxess.

Thermal cross-linking agents with a triazine skeleton are particularly preferred in the present invention. The triazine moiety is believed to contribute to the mechanical properties and heat resistance of the cured film. Any triazine compound having thermal cross-linking properties may be used.

A preferred triazine compound has a chemical structure according to General Formula II, 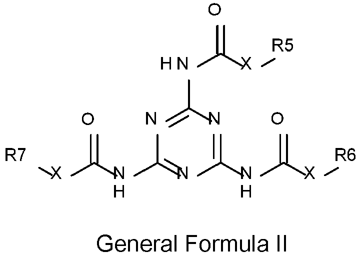
wherein X represents N, O, S, P or C;
R5, R6 and R7 independently from each other represent a substituted or unsubstituted alkyl group;
X preferably represents O or C, most preferably O.
Preferably, R5, R6 and R7 independently from each other represent a substituted or unsubstituted C1-C8 alkyl group. More preferably, R5, R6 and R7 independently from each other represent a group selected from the group consisting of methyl, ethyl, n-propyl, i-propyl, butyl, n-octyl, 2-ethyl hexyl.

Preferred triazine compounds according to General Formula II and their preparation method are disclosed in US5084541 (American Cyanamid Company).

Preferred triazine compounds according to General Formula II are commercially available from Allnex under the name Cymel^{®} NF 2000 and from BASF under the name Larotact^{®} 150.

The inkjet ink according to the present invention preferably includes a blocked isocyanate compound or a triazine compound according to General Formula II.

More preferably, the inkjet ink includes both a blocked isocyanate and a triazine compound according to General Formula II.

The total amount of thermal cross-linking agents is preferably from 0.5 to 15 wt%, more preferably from 1 to 10 wt%, most preferably from 2.5 to 7.5 wt%, all relative to the total weight of the inkjet inks.

The amount of the blocked isocyanate compound is preferably from 0.1 to 10 wt%, more preferably from 1 to 7.5 wt%, most preferably from 2 to 5 wt%, all relative to the total weight of the inkjet ink.

The amount of the triazine compound is preferably from 0.1 to 5 wt%, more preferably from 0.5 to 4 wt%, most preferably from 1 to 3 wt%, all relative to the total weight of the inkjet ink.

When both a triazine compound and an isocyanate compound are present in the inkjet ink, the amount of the blocked isocyanate compound is preferably higher compared to the amount of the triazine compound.

It has been observed that the presence of thermal cross-linking agents improves various solder resist properties such as resistance to heat, hardness, resistance to soldering heat, resistance to chemicals, electrical insulating properties, and resistance to electroless plating and immersion plating.

### Photoinitiators

The curable inkjet composition comprises a photoinitiator, preferably a free radical photoinitiator.

A free radical photoinitiator is a chemical compound that initiates polymerization of monomers and oligomers when exposed to actinic radiation by the formation of a free radical. A Norrish Type I initiator is an initiator which cleaves after excitation, yielding the initiating radical immediately. A Norrish type II-initiator is a photoinitiator which is activated by actinic radiation and forms free radicals by hydrogen abstraction from a second compound that becomes the actual initiating free radical. This second compound is called a polymerization synergist or co-initiator. Both type I and type II photoinitiators can be used in the present invention, alone or in combination.

Suitable photoinitiators are disclosed in CRIVELLO, J.V., et al. Photoinitiators for Free Radical, Cationic and Anionic Photopolymerization. 2nd edition. Edited by BRADLEY, G. London, UK: John Wiley and Sons Ltd, 1998. p.276-293.

Specific examples of free radical photoinitiators may include, but are not limited to, the following compounds or combinations thereof: benzophenone and substituted benzophenones; 1-hydroxycyclohexyl phenyl ketone; thioxanthones such as isopropylthioxanthone; 2-hydroxy-2-methyl-1-phenylpropan-1-one; 2-benzyl-2-dimethylamino- (4-morpholinophenyl) butan-1-one; benzyl dimethylketal; 2-methyl-1- [4- (methylthio) phenyl] -2-morpholinopropan-1-one; 2,2-dimethoxy-1, 2-diphenylethan-1-one or 5,7-diiodo-3- butoxy-6-fluorone.

A preferred photoinitiator is a thioxanthone compound, such as Darocur ITX, an isomeric mixture of 2- and 4-isopropylthioxanthone, or Genocure DETX, 2,4-diethylthioxanthone. Genocure DETX has a more favourable toxicological profile compared to Darocur ITX.

Another preferred photoinitiator is an acylphosphine oxide compound. The acylphosphine oxide compound may be selected from the group consisting of a mono-acylphosphine oxide and a di-acylphosphine oxide. Preferred acylphosphine oxide photoinitiators are diphenyl(2,4,6-trimethylbenzoyl)phosphine oxide (TPO), ethyl (2,4,6-trimethylbenzoyl) phenyl phosphinate (TPO-L), phenylbis(2,4,6-trimethylbenzoyl)phosphine oxide) (BAPO), bis (2,6- dimethyl-benzoyl)-2,4,4-trimethylpentylphosphine oxide and 2,4,6-trimethoxybenzoyl-diphenylphosphine oxide.

Other preferred photoinitiators are α-hydroxy-ketone Type I photoinitiators such as for example oligo[2-hydroxy-2-methyl-1-[4-(1-methylvinyl-phenyl]propanone] available as Esacure^{®} KIP IT from IGM resins.

A preferred amount of photoinitiator is from 0.2 to 20 wt%, more preferably from 0.5 to 10 wt%, most preferably from 1 to 8 wt%, particularly preferred from 1.5 to 6 wt%, all relative to the total weight of the curable inkjet composition.

In order to increase the photosensitivity further, the curable inkjet composition may additionally contain co-initiators. Suitable examples of co-initiators can be categorized in three groups:
(1) tertiary aliphatic amines such as methyldiethanolamine, dimethylethanolamine, triethanolamine, triethylamine and N-methylmorpholine;
(2) aromatic amines such as amylparadimethyl-aminobenzoate, 2-n-butoxyethyl-4-(dimethylamino) benzoate, 2-(dimethylamino)-ethylbenzoate, ethyl-4-(dimethyl-amino)benzoate, and 2-ethylhexyl-4-(dimethylamino)benzoate; and
(3) (meth)acrylated amines such as dialkylamino alkyl(meth)acrylates (e.g., diethyl-aminoethylacrylate) or N-morpholinoalkyl-(meth)acrylates (e.g., N-morpholinoethyl-acrylate).

Preferred co-initiators are aminobenzoates. A preferred low molecular aminobenzoate is Genocure^{®} EPD from RAHN. Particularly preferred aminobenzoate co-initiators are selected from the group consisting of polymerisable, oligomeric and polymeric aminobenzoate co-initiators.

Polymerisable co-initiators are disclosed in EP-A 2033949 (Agfa Graphics N.V.).

In a more preferred embodiment, the aminobenzoate co-initiators are oligomeric aminobenzoate derivatives. Particularly preferred aminobenzoates are polyether derivatives of aminobenzoates, wherein the polyether is selected from the group consisting of polyethylene oxide), polypropylene oxide), copolymers thereof, and poly(tetrahydrofuran), ethoxylated or propoxylated neopentyl glycol, ethoxylated or propoxylated trimethylpropane and ethoxylated or propoxylated pentaerythritol. Preferred oligomeric aminobenzoates are disclosed in WO1996/33157 (Lambson Fine Chemicals Ltd.) and WO2011/030089 (Sun Chemicals B.V.). Typical examples of polyethylene glycol bis p-dimethylaminobenzoate are OMNIPOL ASA, commercially available from IGM Resins and Speedcure 7040, commercially available from Lambson Fine Chemicals.

Other oligomeric or polymeric co-initiators are for example ESACURE A198, a polyfunctional amine from IGM and SARTOMER^{®} CN3755, an acrylated amine co-initiator from ARKEMA.

### Inhibitors

The curable inkjet composition may contain at least one inhibitor for improving the thermal stability of the ink.

Suitable polymerization inhibitors include phenol type antioxidants, hindered amine light stabilizers, phosphor type antioxidants, hydroquinone monomethyl ether commonly used in (meth)acrylate monomers, and hydroquinone, t-butyl-catechol, pyrogallol, 2,6-di-tert.butyl-4-methylphenol (=BHT) may also be used.

Suitable commercial inhibitors are, for example, Sumilizer^{™} GA-80, Sumilizer^{™} GM and Sumilizer^{™} GS produced by Sumitomo Chemical Co. Ltd.; Genorad^{™} 16, Genorad^{™}18 and Genorad^{™} 20 from Rahn AG; Irgastab^{™}UV10 and Irgastab^{™} UV22, Tinuvin^{™} 460 and CGS20 from Ciba Specialty Chemicals; Floorstab^{™} UV range (UV-1, UV-2, UV-5 and UV-8) from Kromachem Ltd, Additol^{™} S range (S100, S110, S120 and S130) from Cytec Surface Specialties.

Since excessive addition of these polymerization inhibitors may lower the curing speed, it is preferred that the amount capable of preventing polymerization is determined prior to blending. The amount of a polymerization inhibitor is preferably lower than 5 wt%, more preferably lower than 3 wt% of the total curable inkjet composition.

### Adhesion promoter

The curable inkjet composition may include an adhesion promoter to further optimize the adhesion of the cured composition to various surfaces, in particular a copper surface.

Any adhesion promoter may be used, for example those disclosed in WO2004/026977 and WO2004/105 both from AVECIA; WO2017/009097 and WO2020/104302 both from Agfa-Gevaert; and WO2018/087059, WO2018087052 WO2018087056 and WO2018087055, all from Agfa-Gevaert/Electra Polymers.

The curable inkjet composition may include one adhesion promoter or a combination of two, three or more different adhesion promoters.

The total amount of adhesion promoters is preferably from 0.1 to 20 wt%, more preferably from 0.5 to 15 wt%, most preferably from 1 to 10 wt%, all relative to the total weight of the inkjet composition.

However, it has been observed that an inkjet composition according to the present invention may have a sufficient adhesion, even after soldering, gold or ENIG plating, in the absence of an adhesion promoter. As the presence of adhesion promoters may result in a worse stability of the inkjet ink, the curable inkjet composition according to the present invention preferably does not contain an adhesion promoter. The amount of adhesion promotor is preferably less than 2.5 wt%, more preferably less than 1 wt%, most preferably less than 0.5 wt %, relative to the total weight of the composition.

### Flame retardant

The curable inkjet composition preferably comprises a flame retardant.

Preferred flame retardants are inorganic flame retardants, such as Alumina Trihydrate and Boehmite; organo-phosphor compounds, such as organo-phosphates (e.g. triphenyl phosphate (TPP), resorcinol bis (diphenylphosphate) (RDP), bisphenol A diphenyl phosphate (BADP), and tricresyl phosphate (TCP)); organo-phosphonates (e.g. dimethyl methylphosphonate (DMMP)); and organophosphinates (e.g. aluminium dimethylphosphinate).

Preferred flame retardants are disclosed in WO2019/121098.

### Colorants

The curable inkjet composition may be a substantially colourless inkjet composition or may include at least one colorant. For example, when the inkjet ink is used as etch resist, the colorant makes the temporary mask clearly visible to the manufacturer of conductive patterns, allowing a visual inspection of quality. When the inkjet composition is used to apply a solder mask it typically contains a colorant. A preferred colour for a solder mask is green, however other colours such as black or red may also be used.

The colorant may be a pigment or a dye, preferably a pigment.

A colour pigment may be chosen from those disclosed by HERBST, Willy, et al. Industrial Organic Pigments, Production, Properties, Applications. 3rd edition. Wiley - VCH, 2004. ISBN 3527305769. Suitable pigments are disclosed in paragraphs [0128] to [0138] of WO2008/074548.

Pigment particles in inkjet inks should be sufficiently small to permit free flow of the ink through the inkjet-printing device, especially at the ejecting nozzles. It is also desirable to use small particles for maximum colour strength and to slow down sedimentation. Most preferably, the average pigment particle size is not larger than 150 nm. The average particle size of pigment particles is preferably determined with a Brookhaven Instruments Particle Sizer BI90plus based upon the principle of dynamic light scattering.

Generally, dyes exhibit a higher light fading than pigments, but cause no problems on jettability. It was found that anthraquinone dyes exhibit only minor light fading under the normal UV curing conditions used in UV curable inkjet printing. In a preferred embodiment, the colorant in the curable inkjet ink is an anthraquinone dye, such as Macrolex^{™} Blue 3R (CASRN 325781-98-4) from LANXESS.

Other preferred dyes include crystal violet and a copper phthalocyanine dye.

It is possible to combine different colorants to obtain the desired colour, or to improve the dispersion stability. A preferred combination of colorants to obtain a green solder mask is a combination of a blue and a yellow colorant. In a particularly preferred embodiment, a combination of pigment yellow 150 and pigment blue 15:4 is used.

In a preferred embodiment, the colorant is present in an amount of 0.5 to 6.0 wt%, more preferably 0.75 to 2.5 wt%, based on the total weight of the curable inkjet ink.

### Polymeric dispersants

If the colorant in the curable inkjet ink is a pigment, then the curable inkjet ink preferably contains a dispersant, more preferably a polymeric dispersant, for dispersing the pigment.

Suitable polymeric dispersants are copolymers of two monomers but they may contain three, four, five or even more monomers. The properties of polymeric dispersants depend on both the nature of the monomers and their distribution in the polymer. Copolymeric dispersants preferably have the following polymer compositions:
- statistically polymerized monomers (e.g. monomers A and B polymerized into ABBAABAB);
- alternating polymerized monomers (e.g. monomers A and B polymerized into ABABABAB);
- gradient (tapered) polymerized monomers (e.g. monomers A and B polymerized into AAABAABBABBB);
- block copolymers (e.g. monomers A and B polymerized into AAAAABBBBBB) wherein the block length of each of the blocks (2, 3, 4, 5 or even more) is important for the dispersion capability of the polymeric dispersant;
- graft copolymers (graft copolymers consist of a polymeric backbone with polymeric side chains attached to the backbone); and
- mixed forms of these polymers, e.g. blocky gradient copolymers.

Suitable polymeric dispersants are listed in the section on "Dispersants", more specifically [0064] to [0070] and [0074] to [0077], in EP-A 1911814.

Commercial examples of polymeric dispersants are the following:
- DISPERBYK^{™} dispersants available from BYK CHEMIE GMBH;
- SOLSPERSE^{™} dispersants available from LUBRIZOL;
- TEGOTM DISPERS^{™} dispersants from EVONIK;
- EDAPLAN^{™} dispersants from MÜNZING CHEMIE;
- ETHACRYL^{™} dispersants from LYONDELL;
- GANEX^{™} dispersants from ISP;
- DISPEX^{™} and EFKA^{™} dispersants from BASF;
- DISPONER^{™} dispersants from DEUCHEM; and
- JONCRYL^{™} dispersants from BASF.

### Surfactants

The curable inkjet composition may contain at least one surfactant, which may act as wetting agent, dispersant or emulsifier.

The surfactant can be anionic, cationic, non-ionic, or zwitter-ionic.

Suitable surfactants include fluorinated surfactants, fatty acid salts, ester salts of a higher alcohol, alkylbenzene sulfonate salts, sulfosuccinate ester salts and phosphate ester salts of a higher alcohol (for example, sodium dodecylbenzenesulfonate and sodium dioctylsulfosuccinate), ethylene oxide adducts of a higher alcohol, ethylene oxide adducts of an alkylphenol, ethylene oxide adducts of a polyhydric alcohol fatty acid ester, and acetylene glycol and ethylene oxide adducts thereof (for example, polyoxyethylene nonylphenyl ether, and SURFYNOL^{™} 104, 104H, 440, 465 and TG available from AIR PRODUCTS & CHEMICALS INC.).

Preferred surfactants are selected from fluorinated surfactants (such as fluorinated hydrocarbons) and silicone surfactants. The silicone surfactants are preferably siloxanes and can be alkoxylated, polyether modified, polyether modified hydroxy functional, amine modified, epoxy modified and other modifications or combinations thereof. Preferred siloxanes are polymeric, for example polydimethylsiloxanes.

Preferred commercial silicone surfactants include BYK^{™} 333, BYK^{™} 347 and BYK^{™} UV3510 from BYK Chemie.

In a preferred embodiment, the surfactant is a polymerizable compound.

Preferred polymerizable silicone surfactants include a (meth)acrylated silicone surfactant. Most preferably the (meth)acrylated silicone surfactant is an acrylated silicone surfactant, because acrylates are more reactive than methacrylates. A preferred commercial acrylated surfactant is Ebecryl 1360 from Allnex.

In a preferred embodiment, the (meth)acrylated silicone surfactant is a polyether modified (meth)acrylated polydimethylsiloxane or a polyester modified (meth)acrylated polydimethylsiloxane.

Preferably the surfactant is present in the curable inkjet composition in an amount of 0 to 3 wt% based on the total weight of the curable inkjet composition.

### Preparation of the inkjet composition

The preparation of pigmented curable inkjet inks is well-known to the skilled person. Preferred methods of preparation are disclosed in paragraphs [0076] to [0085] of WO2011/069943.

### Method of manufacturing an electronic device

The method of manufacturing an electronic device according to the present invention includes at least one step wherein a curable inkjet composition as described above is jetted and cured on a substrate.

According to a preferred embodiment, the electronic device is a Printed Circuit Board (PCB).

In a particular preferred embodiment, the method of manufacturing a PCB includes a step wherein the solder mask composition is applied on the substrate via an inkjet printing step, followed with a UV-curing step and a heat treatment step.

The substrate is preferably a dielectric substrate containing an electrically conductive pattern, which typically comprises conductive pads electrically connected with each other using traces.

The dielectric substrate of the electronic device may be any non-conductive material. The substrate is typically a paper/resin composite or a resin/fibre glass composite, a ceramic substrate, a polyester or a polyimide. FR-4 is an example of a material frequently used as dielectric substrate.

The electrically conductive pattern is typically made from any metal or alloy which is conventionally used for preparing electronic devices such as gold, silver, palladium, nickel/gold, nickel, tin, tin/lead, aluminium, tin/aluminium and copper. The electrically conductive pattern is preferably made from copper.

Before applying the solder mask composition, the substrate is preferably subjected to one or more pre-treatment processes. These processes can be mechanical or chemical, or a combination thereof. A preferred pre-treatment process is chemical micro-etching, which typically results in micro-roughness on the substrate. A so-called anti-bleeding treatment can be additionally applied to the micro-etched surface to prevent bleeding of the ink into the micro-pores and to improve print quality. This anti-bleeding treatment typically comprises applying a coating layer on the substrate in order to adjust its surface energy, resulting in sharper contact angles and minimal bleeding of ink into micro-pores. Anti-bleeding treatments are preferably used when printing low-viscous compositions.

The process of inkjet printing the solder mask layer on a dielectric substrate with an electrically conductive pattern preferably comprises one or more printing steps as listed below.

The printing of so-called "ramps" comprises printing lines next to the copper traces. This preparative printing step ensures a sufficient coverage of the Cu traces. If no ramps are printed next to the copper traces, the cured solder mask may be too thin on the edges (also called shoulders) of the copper traces. The thickness of the printed ramps is related to the height of the plated Cu traces. For plated Cu traces having a large height, a higher ramp ink thickness is required in order to have sufficient coverage on the Cu edges. For plated Cu traces with a lower height, a lower ramp thickness may be used. The ramps preferably have a thickness of 0 to 80 µm, more preferably from 10 to 60 µm, most preferably from 20 to 40 µm.

The printing of so-called "dams" is usually done to indicate the contours of the entire solder mask layer. These dams are usually cured with higher curing energies to provide precise features and lines. The thickness of the dams is preferably at least the same as the thickness of the full solder mask layer. The thickness of the dams is more preferably higher than the thickness of the full solder mask layer, in order to avoid possible ink flow towards the open pad. The dams preferably have a thickness of 5 to 75 µm, more preferably from 10 to 60 µm, most preferably from 20 to 40 µm.

Finally, the entire board is printed within the contours of the dams, covering the Cu traces, but leaving open the Cu pads for soldering.

The curable inkjet composition may be cured by exposing the composition to actinic radiation, such as electron beam or ultraviolet (UV) radiation. Preferably the curable inkjet composition is cured by UV radiation, more preferably using UV LED curing. To fixate the curable composition on the substrate, a UV pin curing step may be used immediately after printing. This UV pin curing may improve the print quality.

A heat treatment is preferably applied to the jetted and UV-cured curable inkjet composition. The heat treatment is preferably carried out at a temperature of from 80 °C and 250°C. The temperature is preferably not less than 100°C, more preferably not less than 120 °C. To prevent charring of the solder mask, the temperature is preferably not higher than 200 °C, more preferably not higher than 160 °C.

The thermal treatment is typically carried out from 15 to 90 minutes.

The purpose of the thermal treatment is two-fold: curing thermal cross-linking agents present in the curable composition, and further polymerizing potentially non-reacted radiation curable compounds. A dense interpenetrating polymer network can thus be created.

The method of manufacturing a PCB may comprise two, three or more inkjet printing steps. For example, the method may comprise two inkjet printing steps wherein an etch resist is provided on a metal surface in one inkjet printing step and wherein a solder mask is provided on a dielectric substrate containing an electrically conductive pattern in another inkjet printing step.

A third inkjet printing step may be used for legend printing.

### Inkjet printing devices

The curable inkjet composition may be jetted by one or more print heads ejecting small droplets in a controlled manner through nozzles onto a substrate, which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However, the inkjet printing method according to the present invention is not restricted to piezoelectric inkjet printing. Other inkjet print heads can be used and include various types, such as a continuous type.

The inkjet print head normally scans back and forth in a transversal direction across the moving ink-receiving surface (substrate). Often the inkjet print head does not print on the way back. Bi-directional printing is preferred for obtaining a high areal throughput. Another preferred printing method is by a "single pass printing process", which can be performed by using page wide inkjet print heads or multiple staggered inkjet print heads which cover the entire width of the ink-receiving surface. In a single pass printing process, the inkjet print heads usually remain stationary and the ink-receiving surface is transported under the inkjet print heads.

### Examples

### Materials

All materials used in the following examples were readily available from standard sources such as ALDRICH CHEMICAL Co. (Belgium) and ACROS (Belgium) unless otherwise specified. The water used was deionized water.

SR833s is tricyclodecanedimethanol diacrylate available as Sartomer^{™} SR833S from ARKEMA with CAS registry number 42594-17-2.

HDDA is hexanediol diacrylate available as Sartomer^{™} SR238 from ARKEMA.

SR789 is tricyclodecanemethanol acrylate available as Sartomer^{™} SR789 from ARKEMA with CAS registry number 93962-84-6.

VMOX is N-vinyl-5-methyl-2-oxazolidinone available from BASF.

TBCH is 4-tert-butylcyclohexylacrylate available as LAROMER TBCH from BASF.

DETX is a 2,4-diethylthioxanthone photoinitiator available as Genocure DETX from Rahn.

BAPO is a bis(2,4,6-trimethylbenzoyl)-phenylphosphineoxide photoinitiator available as Irgacure^{™} 819 from BASF.

BISAPHOS is a flame retardant containing a mixture of aromatic polyphosphates available from ADEKA.

Trixene BI7960 is a DMP-blocked isocyanate cross-linking agent commercially available from LANXESS.

Cymel NF2000A is a triazine cross-linking agent commercially available from ALLNEX.

Pripol 1013 is a distilled dimer fatty acid supplied by Equus Germany GmbH, having an acid value of 194 - 198 mg KOH/gram.

Pripol 2043 is a fatty acid dimer diol supplied by Equus Germany GmbH, having a hydroxyl value of 200 - 214 mg KOH/gram.

Pripol 1009 is a hydrogenated, distilled dimer fatty acid supplied by Equus Germany GmbH, having an acid value of 194-198 mg KOH/gram.

Pripol 2033 is a dimer fatty acid diol supplied by Equus Germany GmbH, having a hydroxyl value of 202 - 212 mg KOH/gram.

Priplast 1837 is a dimer fatty acid based polyester supplied by Equus Germany GmbH, having a molecular weight (MW) of 1000 g/mol and a hydroxyl value of 100 - 120 mg KOH/gram.

Priplast 1838 is a dimer fatty acid based polyester supplied by Equus Germany GmbH, having a molecular weight (MW) of 2000 g/mol and a hydroxyl value of 52 - 60 mg KOH/gram.

Priplast 3186 is a dimer fatty acid based polyester supplied by Equus Germany GmbH, having a molecular weight (MW) of 1700 g/mol and a hydroxyl value of 68 - 83 mg KOH/gram.

Priplast 3238 is a dimer fatty acid based polyester supplied by Equus Germany GmbH, having a molecular weight (MW) of 2000 g/mol and a hydroxyl value of 52 - 60 mg KOH/gram.

Priplast 3197 is a dimer fatty acid based polyester supplied by Equus Germany GmbH, having a molecular weight (MW) of 2000 g/mol and a hydroxyl value of 52 - 60 mg KOH/gram.

B tough UV20 is a dimer fatty acid based polyester diacrylate supplied by Equus Germany GmbH.

Ebecryl 1360 is a silicone hexa-acrylate available from ALLNEX.

WET is a 1% solution of Ebecryl 1360 in VEEA.

Cyan is SUN FAST BLUE 15:4, a cyan pigment available from SUN CHEMICALS.

Yellow is CROMOPHTAL YELLOW D 1085J, a yellow pigment from BASF.

INHIB is a mixture forming a polymerization inhibitor having a composition according to Table 1.

**Table 1**

| **Component** | **wt%** |
|---|---|
| DPGDA | 82.4 |
| p-methoxyphenol | 4.0 |
| 2,6-di-tert-butyl-4-methylphenol | 10.0 |
| Cupferron^{™} AL | 3.6 |

Cupferron^{™} AL is aluminium N-nitrosophenylhydroxylamine from WAKO CHEMICALS LTD.

PRECIP 162 is a dispersing agent and has been precipitated from Disperbyk 162, a dispersant solution available from BYK (ALTANA).

DISP is a solution of 30 wt% PRECIP 162 and 1 wt% INHIB in VEEA.

GD is a green dispersion prepared as follows:
A concentrated green dispersion, GD, was prepared having a composition according to Table 2.

**Table 2**

| **Component** | **wt%** |
|---|---|
| Cyan | 7.5 |
| Yellow | 7.5 |
| DISP | 15 |
| INHIB | 1 |
| VEEA | 69 |

GD was prepared as follows: 138 g of VEEA, 2 g of INHIB, 30 g of DISP, 30 g of Cyan and 30 g of Yellow were mixed using a DISPERLUX^{™} dispenser. Stirring was continued for 30 minutes. The vessel was connected to a NETZCH MiniZeta mill filled with 900 g of 0.4 mm yttrium stabilized zirconia beads ("high wear resistant zirconia grinding media" from TOSOH Co.). The mixture was circulated over the mill over 120 minutes (residence time of 45 minutes) and a rotation speed in the mill of about 10.4 m/s. During the complete milling procedure, the content in the mill was cooled to keep the temperature below 60°C. After milling, the dispersion was discharged into a vessel.

### Evaluation methods

### IR Reflow

A 40 µm coating on FR-4 EM 825 is prepared by coating a 20 µm layer of the ink and curing 4 times using a 12W UV LED lamp with a belt moving at 20 m/min. Then, a second 20 µm layer was applied and cured in the same way. Finally, the 40 µm coating is put in an oven for 1 hour at 150 °C.

Next a crosshatch was applied to the coating. This will serve a possible starting point for crack formation and is considered a harsh test for the coatings to pass.

IR reflow evaluation is done using an eC-reflow-mate V4 reflow oven. The temperature inside the reflow oven is measured by three sensors. One at the top, one at the bottom and finally a central sensor to measure the temperature of the samples. The 40 µm coating is put into the IR eC-reflow-mate V4 reflow oven and placed above the central temperature sensor. The reflow cycle begins by heating up the oven to 260 °C. Once the sample temperature has reached 260 °C, the oven holds the temperature for 10 seconds after which the sample is cooled down at open air. The duration of one cycle is 4min 30s. The ink coating undergoes up to 12 IR reflow cycles (C1 to C12).

The evaluation of the samples is done visually by counting the number of cracks after each cycle. When there are 3 or more marks observed, the coating has failed the test and the test is stopped.

### Viscosity

The viscosity of the inks was measured at 45 °C and at a shear rate of 1000 s⁻¹ using a HAAKE RotoVisco 1.

For industrial inkjet printing, the viscosity at 45 °C and at a shear rate of 1000 s⁻¹ is preferably between 5.0 and 15 mPa.s. More preferably, the viscosity at 45 °C and at a shear rate of 1000 s⁻¹ is less than 15 mPa.s.

### ENIG Resistance

An ENIG simulation was carried out using a procedure as described below:

The boards were dipped in a bath of acid cleaner (Umicore cleaner 865) at 40 °C during 4 min. The boards were then removed and dipped in a rinsing bath of deionized water (DW) at room temperature (RT) during 90 seconds.

The boards were dipped in a microetching bath comprising 8.5 wt% Na₂S₂0₈ and ± 3.2 wt% H₂SO₄ (98 %) in water at a temperature between 26-33 °C for 100 s. The boards were then removed and rinsed in respectively DW, a 2.5 wt% aqueous H₂SO₄ solution and DW, all at RT during 90 seconds.

The boards were dipped in 2.5 wt% aqueous H₂SO₄ solution at RT during 30 seconds after which they were removed and rinsed in DW at RT during 90 seconds. They were then dipped again in the same solution during 60 seconds. The boards were dipped in a palladium activator bath (Accemulta MKN 4) at a temperature around 30 °C for 90 s followed by dipping in a 5 wt% aqueous H₂SO₄ solution at RT during 75 seconds. The boards were then removed and dipped in a rinsing bath of DW at RT during 90 seconds.

Then the boards were dipped in a nickel bath (Nimuden NPR 4) at a temperature around 85 °C for 35 min. The boards were then removed and dipped in a rinsing bath of DW at RT during 90 s.

Finally, the boards were dipped in a gold bath (Gobright TAM 55) at a temperature around 80 °C for 12 min. The boards were then removed and dipped in a rinsing bath of DW at RT during 90 s.

After ENIG treatment, it is possible that a so-called halo effect occurs, especially around open pads. In these areas, it appears that the ENIG solution penetrates and lifts the solder mask layer, which can be observed as an area around an open pad having a different appearance. This phenomenon could create weak adhesion points of the solder mask onto the substrate and may result in peeling off from the layer.

The occurrence of halo effect was evaluated microscopically with a digital microscope Dino-LITE and scored with a value from 0 to 5, depending on the observed width of the Halo.
0: No Hallo effect visible.
1: Halo width less than 1 mm.
2: Halo width from 1 mm to 2 mm.
3: Halo width from 2 mm to 3 mm.
4: Halo width from 3 mm to 4 mm.
5: Halo width more than 4 mm.

The adhesion after ENIG plating was evaluated with cross hatch adhesion test using Tesatape^{™} 4104 PVC tape. The evaluation was made in accordance with a criterion described below. The adhesion was evaluated both on Cu and FR-4.
0: Nothing removed, perfect adhesion.
1: Detachment of only very small parts of the cured layer, almost perfect adhesion.
2: Minor parts of the cured layer were removed by the tape, good adhesion.
3: Parts of the cured layer were removed by the tape, poor adhesion.
4: Most of the cured layer was removed by the tape, poor adhesion.
5: The cured layer was completely removed from the substrate by the tape, no adhesion.

### Comparative examples 1 to 5 and Examples 1 to 5.

The comparative curable inkjet composition Comp-1 to Comp-5 and the curable inkjet composition Ex-1 to Ex-5 were prepared according to Table 3. The weight percentages are based on the total weight of the curable inkjet composition.

In this set of experiments, different types of dimer fatty acid and dimer fatty diol products and polyesters thereof are evaluated. A first set of evaluated products (Comp-2 to Comp-5) are dimer fatty acids and dimer fatty diols commercially known under the trademark "Pripol". These products typically have lower molecular weights because they are non-polymerized dimers. A second type of products tested in this set of experiments (Ex-1 to Ex-5) are polyesters comprising dimer fatty acids or dimer fatty diols, commercially known under the trademark "Priplast". All the formulations have the same composition in wt%, wherein only the type of dimer fatty acid derivative is varied. Comp-1 does not contain any dimer fatty acid compound and to compensate for this absence, the amount of monofunctional SR789 is 5 wt% higher than in the other formulations.

**Table 3**

| | **Comp -1** | **Comp -2** | **Comp -3** | **Comp -4** | **Comp -5** | **Ex-1** | **Ex-2** | **Ex-3** | **Ex-4** | **Ex-5** |
|---|---|---|---|---|---|---|---|---|---|---|
| **GD** | 6.6 | 6.6 | 6.6 | 6.6 | 6.6 | 6.6 | 6.6 | 6.6 | 6.6 | 6.6 |
| **HDDA** | 13 | 13 | 13 | 13 | 13 | 13 | 13 | 13 | 13 | 13 |
| **SR833s** | 10 | 10 | 10 | 10 | 10 | 10 | 10 | 10 | 10 | 10 |
| **SR789** | 33.8 | 28.8 | 28.8 | 28.8 | 28.8 | 28.8 | 28.8 | 28.8 | 28.8 | 28.8 |
| **VMOX** | 7.5 | 7.5 | 7.5 | 7.5 | 7.5 | 7.5 | 7.5 | 7.5 | 7.5 | 7.5 |
| **TBCH** | 10.6 | 10.6 | 10.6 | 10.6 | 10.6 | 10.6 | 10.6 | 10.6 | 10.6 | 10.6 |
| **Pripol 1013** | - | 5 | - | - | - | - | - | - | - | - |
| **Pripol 2043** | - | - | 5 | - | - | - | - | - | - | - |
| **Pripol 1009** | - | - | - | 5 | - | - | - | - | - | - |
| **Pripol 2033** | - | - | - | - | 5 | - | - | - | - | - |
| **Priplast 1837** | - | - | - | - | - | 5 | - | - | - | - |
| **Priplast 1838** | - | - | - | - | - | - | 5 | - | - | - |
| **Priplast 3186** | - | - | - | - | - | - | - | 5 | - | - |
| **Priplast 3238** | - | - | - | - | - | - | - | - | 5 | - |
| **Priplast 3197** | - | - | - | - | - | - | - | - | - | 5 |
| **BAPO** | 4.7 | 4.7 | 4.7 | 4.7 | 4.7 | 4.7 | 4.7 | 4.7 | 4.7 | 4.7 |
| **DETX** | 3.0 | 3.0 | 3.0 | 3.0 | 3.0 | 3.0 | 3.0 | 3.0 | 3.0 | 3.0 |
| **BISAPHO S** | 2.0 | 2.0 | 2.0 | 2.0 | 2.0 | 2.0 | 2.0 | 2.0 | 2.0 | 2.0 |
| **Trixene BI7960** | 3.5 | 3.5 | 3.5 | 3.5 | 3.5 | 3.5 | 3.5 | 3.5 | 3.5 | 3.5 |
| **Cymel NF2000A** | 2.4 | 2.4 | 2.4 | 2.4 | 2.4 | 2.4 | 2.4 | 2.4 | 2.4 | 2.4 |
| **WET** | 2.0 | 2.0 | 2.0 | 2.0 | 2.0 | 2.0 | 2.0 | 2.0 | 2.0 | 2.0 |
| **INHIB** | 0.9 | 0.9 | 0.9 | 0.9 | 0.9 | 0.9 | 0.9 | 0.9 | 0.9 | 0.9 |
| | | | | | | | | | | |
| **Viscosity (mPa.s)** | 8.14 | 8.65 | 8.56 | 8.69 | 8.75 | 11.2 0 | 13.4 3 | 13.5 5 | 13.8 0 | 13.3 4 |

The IR reflow resistance was evaluated as described above and the results are shown in Table 4.

**Table 4**

| | **IR reflow resistance** | | | | | | | | | | | |
|---|---|---|---|---|---|---|---|---|---|---|---|---|
| | **C1** | **C2** | **C3** | **C4** | **C5** | **C6** | **C7** | **C8** | **C9** | **C10** | **C11** | **C12** |
| **Comp-1** | 0 | 0 | 0 | 0 | 0 | 0 | >3 | | | | | |
| **Comp-2** | 0 | 0 | 0 | 0 | 0 | 2 | >3 | | | | | |
| **Comp-3** | 0 | 0 | 0 | 0 | 2 | >3 | | | | | | |
| **Comp-4** | 0 | 0 | 0 | 0 | 3 | >3 | | | | | | |
| **Comp-5** | 0 | 0 | 0 | 0 | 1 | >3 | | | | | | |
| **Ex-1** | 0 | 0 | 0 | 0 | 0 | 0 | 2 | >3 | | | | |
| **Ex-2** | 0 | 0 | 0 | 0 | 0 | 0 | 0 | 0 | 0 | 0 | 0 | 0 |
| **Ex-3** | 0 | 0 | 0 | 0 | 0 | 0 | 0 | 2 | >3 | | | |
| **Ex-4** | 0 | 0 | 0 | 0 | 0 | 0 | 0 | 0 | 0 | 0 | >3 | |
| **Ex-5** | 0 | 0 | 0 | 0 | 0 | 0 | 0 | 0 | 0 | 0 | >3 | |

All inks comprising a polyester comprising fatty acid dimers show improved IR reflow resistance compared to inks not comprising these polyesters. Preferably, a polyester with a molecular weight of more than 1000 g/mol is used. When the molecular weight of the polyester is higher than 1000 g/mol, the IR reflow resistance is improved. Preferably, a linear polyester is used. When the polyester has a functionality of 2, the IR reflow resistance is even further improved compared to when the ink comprises a polyester having a functionality of more than 2 (Ex-3).

### Comparative example 6 to 7 and Examples 6 to 7.

The comparative curable inkjet compositions Comp-6 and Comp-7 and the curable inkjet composition Ex-6 to Ex-7 were prepared according to Table 5. The weight percentages are based on the total weight of the curable inkjet composition.

In these examples, the amount of the polyester polyol Priplast 1838 is steadily increased, while the amount of monofunctional SR789 is decreased accordingly. All other compounds are kept constant.

**Table 5**

| | **Comp-6** | **Comp-7** | **Ex-6** | **Ex-7** |
|---|---|---|---|---|
| **GD** | 6.6 | 6.6 | 6.6 | 6.6 |
| **HDDA** | 15 | 15 | 15 | 15 |
| **SR833s** | 10 | 10 | 10 | 10 |
| **SR789** | 31.8 | 29.3 | 26.8 | 24.3 |
| **VMOX** | 7.5 | 7.5 | 7.5 | 7.5 |
| **TBCH** | 10.6 | 10.6 | 10.6 | 10.6 |
| **Priplast 1838** | - | 2.5 | 5 | 7.5 |
| **BAPO** | 4.7 | 4.7 | 4.7 | 4.7 |
| **DETX** | 3.0 | 3.0 | 3.0 | 3.0 |
| **BISAPHOS** | 2.0 | 2.0 | 2.0 | 2.0 |
| **Trixene BI7960** | 3.5 | 3.5 | 3.5 | 3.5 |
| **Cymel N F2000A** | 2.4 | 2.4 | 2.4 | 2.4 |
| **WET** | 2.0 | 2.0 | 2.0 | 2.0 |
| **INHIB** | 0.9 | 0.9 | 0.9 | 0.9 |
| | | | | |
| **Viscosity (mPa.s)** | 7.85 | 9.74 | 11.97 | 14.45 |

The IR reflow resistance was evaluated as described above and the results are shown below in Table 6.

**Table 6**

| | **IR reflow resistance** | | | | | | | | | | | |
|---|---|---|---|---|---|---|---|---|---|---|---|---|
| | **C1** | **C2** | **C3** | **C4** | **C5** | **C6** | **C7** | **C8** | **C9** | **C10** | **C11** | **C12** |
| **Comp-6** | 0 | 0 | 0 | >3 | | | | | | | | |
| **Comp-7** | 0 | 0 | 0 | 0 | 2 | >3 | | | | | | |
| **Ex-6** | 0 | 0 | 0 | 0 | 0 | 0 | 0 | 0 | 0 | 0 | 1 | 2 |
| **Ex-7** | 0 | 0 | 0 | 0 | 0 | 0 | 0 | 0 | 0 | 0 | 0 | 0 |

Inks containing Priplast 1838 have a better IR reflow resistance compared to an ink without the polyester polyol and increasing amounts of Priplast result in a further improvement of the IR reflow resistance. However, a too high amount of polyester polyol could possibly impact the overall viscosity of the curable inkjet composition and thus its jetting behavior.

### Comparative examples 8 to 9 and Examples 8 to 9.

The comparative curable inkjet compositions Comp-8 to Comp-9 and the curable inkjet compositions Ex-8 to Ex-9 were prepared according to Table 7. The weight percentages are based on the total weight of the curable inkjet composition.

In these examples, the amount of B Tough UV20 is steadily increased, while the amount of monofunctional SR789 is decreased accordingly. All other compounds are kept constant. B Tough UV20 is an UV-curable polyester diacrylate based on dimer fatty acids.

**Table 7**

| | **Comp-8** | **Comp-9** | **Ex-8** | **Ex-9** |
|---|---|---|---|---|
| **GD** | 6.6 | 6.6 | 6.6 | 6.6 |
| **HDDA** | 15 | 15 | 15 | 15 |
| **SR833s** | 10 | 10 | 10 | 10 |
| **SR789** | 31.8 | 29.3 | 26.8 | 24.3 |
| **VMOX** | 7.5 | 7.5 | 7.5 | 7.5 |
| **TBCH** | 10.6 | 10.6 | 10.6 | 10.6 |
| **B tough UV20** | - | 2.5 | 5 | 7.5 |
| **BAPO** | 4.7 | 4.7 | 4.7 | 4.7 |
| **DETX** | 3.0 | 3.0 | 3.0 | 3.0 |
| **BISAPHOS** | 2.0 | 2.0 | 2.0 | 2.0 |
| **Trixene BI7960** | 3.5 | 3.5 | 3.5 | 3.5 |
| **Cymel NF2000A** | 2.4 | 2.4 | 2.4 | 2.4 |
| **WET** | 2.0 | 2.0 | 2.0 | 2.0 |
| **INHIB** | 0.9 | 0.9 | 0.9 | 0.9 |
| | | | | |
| **Viscosity (mPa.s)** | 7.85 | 9.61 | 11.78 | 14.23 |

The IR reflow resistance was evaluated as described above and the results are shown below in Table 8.

**Table 8**

| | **IR reflow resistance** | | | | | | | | | | | |
|---|---|---|---|---|---|---|---|---|---|---|---|---|
| | **C1** | **C2** | **C3** | **C4** | **C5** | **C6** | **C7** | **C8** | **C9** | **C10** | **C11** | **C12** |
| **Comp-8** | 0 | 0 | 0 | >3 | | | | | | | | |
| **Comp-9** | 0 | 0 | 1 | >3 | | | | | | | | |
| **Ex-8** | 0 | 0 | 0 | 0 | 0 | 0 | 1 | >3 | | | | |
| **Ex-9** | 0 | 0 | 0 | 0 | 0 | 0 | 0 | 0 | 0 | 0 | 1 | 1 |

Inks comprising B tough UV20 have a better IR reflow resistance than an ink not comprising this polyester comprising fatty acid dimers. From the results, it is clear that when the ink comprises more than 2.5 wt% of the polyester there is an improved IR reflow resistance.

### Comparative examples 10 to 11 and Examples 10 to 13.

The comparative curable inkjet compositions Comp-10 to Comp-11 and the curable inkjet compositions Ex-10 to Ex-13 were prepared according to Table 9. The weight percentages are based on the total weight of the curable inkjet ink composition.

In these examples, the amount of Priplast 1838 is steadily increased, while the amount of monofunctional SR789 is decreased accordingly and the thermal crosslinkers Trixene BI7960 and Cymel NF2000A are removed. All other compounds are kept constant.

**Table 9**

| | **Comp-10** | **Ex-10** | **Ex-11** | **Ex-12** | **Ex-13** | **Comp-11** |
|---|---|---|---|---|---|---|
| **GD** | 6.6 | 6.6 | 6.6 | 6.6 | 6.6 | 6.6 |
| **HDDA** | 15 | 15 | 15 | 15 | 15 | 15 |
| **SR833s** | 10 | 10 | 10 | 10 | 10 | 10 |
| **SR789** | 31.8 | 26.8 | 24.3 | 32.7 | 30.2 | 37.7 |
| **VMOX** | 7.5 | 7.5 | 7.5 | 7.5 | 7.5 | 7.5 |
| **TBCH** | 10.6 | 10.6 | 10.6 | 10.6 | 10.6 | 10.6 |
| **Priplast 1838** | - | 5 | 7.5 | 5 | 7.5 | - |
| **BAPO** | 4.7 | 4.7 | 4.7 | 4.7 | 4.7 | 4.7 |
| **DETX** | 3.0 | 3.0 | 3.0 | 3.0 | 3.0 | 3.0 |
| **BISAPHOS** | 2.0 | 2.0 | 2.0 | 2.0 | 2.0 | 2.0 |
| **Trixene BI7960** | 3.5 | 3.5 | 3.5 | - | - | - |
| **Cymel NF2000A** | 2.4 | 2.4 | 2.4 | - | - | - |
| **WET** | 2.0 | 2.0 | 2.0 | 2.0 | 2.0 | 2.0 |
| **INHIB** | 0.9 | 0.9 | 0.9 | 0.9 | 0.9 | 0.9 |
| | | | | | | |
| **Viscosity (mPa.s)** | 7.85 | 11.97 | 14.45 | 11.01 | 13.78 | 7.01 |

The IR reflow resistance was evaluated as described above and the results are shown below in Table 10.

**Table 10**

| | **IR reflow resistance** | | | | | | | | | | | |
|---|---|---|---|---|---|---|---|---|---|---|---|---|
| | **C1** | **C2** | **C3** | **C4** | **C5** | **C6** | **C7** | **C8** | **C9** | **C10** | **C11** | **C12** |
| **Comp-10** | 0 | 0 | 0 | >3 | | | | | | | | |
| **Ex-10** | 0 | 0 | 0 | 0 | 0 | 0 | 0 | 0 | 0 | 0 | 1 | 2 |
| **Ex-11** | 0 | 0 | 0 | 0 | 0 | 0 | 0 | 0 | 0 | 0 | 0 | 0 |
| **Ex-12** | 0 | 0 | 0 | 0 | 0 | 0 | 0 | 0 | 0 | 0 | 0 | 2 |
| **Ex-13** | 0 | 0 | 0 | 0 | 0 | 0 | 0 | 0 | 0 | 0 | 0 | 0 |
| **Comp-11** | 0 | 0 | 0 | 1 | >3 | | | | | | | |

Inks comprising Priplast 1838 have a better IR reflow resistance. There is no impact when the thermal crosslinkers are removed.

Preferably, the inks also have good adhesion and ENIG resistance. It was shown that the presence of the thermal crosslinkers improves the adhesion and/or the ENIG resistance of the cured solder mask layers, as is clear from Table *11* below.

The inkjet inks were printed using a MicroCraft CPS2013D (Printhead Konica Minolta KM1024iS, UV LED 395 12 W total output of the lamp) on a checkerboard (copper plated on FR4) substrate from Eurocircuits to obtain a soldermask layer having a final thickness of +/- 22 µm. The checkerboards include a 35 µm copper layer that was roughened by chemical etching. In the chemical etching step, the substrate was transported through a Bungard Sprint 3000 Conveyorized Spray Etch machine at a speed of 0.4 m/min while spraying with the chemical etchant CZ2001 (available from MEC) heated at 30°C. After a rinsing step with demineralized water an extra spraying step with 1M HCL was carried out, followed again by a rinsing step with demineralized water and finally a drying step in an Air 2000 dryer (available from Bungard). The substrate was printed within 24 h after this pretreatment.

After printing the samples were baked in an oven at 150°C for 1 hour.

Different printing protocols were used:
Print-1 (P1): An image having a resolution 1440 dpi in the x-direction and 1440 dpi in the y-direction was printed and cured. The UV energy applied corresponded to 10 % of the total power of the 12 W lamp. A final cure was applied to further cure the printed solder mask layer (4 passes at full energy of the 12 W lamp).
Print-2 (P2): Compared to Print 1, the image was printed in the same resolution, but the UV energy applied corresponded to 100 % of the total power of the 12 W lamp. A final cure was then carried out as described for Print-1.

The printed inks were evaluated as described above.

**Table 11**

| | **ADHESION after ENIG** | | | | **ENIG** | |
|---|---|---|---|---|---|---|
| | **Adhesion Cu** | | **Adhesion FR-4** | | **Halo effect** | |
| | **P1** | **P2** | **P1** | **P2** | **P1** | **P2** |
| **Comp-10** | 0 | 0 | 1 | 0 | 0 | 0 |
| **Ex-10** | 0 | 0 | 0 | 1 | 0 | 0 |
| **Ex-11** | 0 | 0 | 0 | 0 | 0 | 0 |
| **Ex-12** | 2 | 1 | 2 | 2 | 2 | 1 |
| **Ex-13** | 0 | 0 | 2 | 3 | 1 | 1 |
| **Comp-11** | 1 | 0 | 2 | 3 | 3 | 3 |

When there are two types of thermal crosslinkers present, both the adhesion and the ENIG resistance improve.

## Claims

1. A curable inkjet composition for a printed circuit board comprising one or more photopolymerizable compounds, a photoinitiator, and a polyester comprising fatty acid dimer units, wherein the amount of polyester is more than 2.5 wt% relative to the total weight of the inkjet ink composition.

2. Curable inkjet composition according to claim 1, wherein the amount of polyester copolymer is less than 10 wt% relative to the total weight of the inkjet ink composition.

3. Curable inkjet composition according to claim 1 or 2, wherein the polyester is a polyester copolymer comprising:
• at least one dimer fatty residue, selected from a dimer fatty acid residue and a dimer fatty diol residue; and
• at least one residue of a linear or branched C2 to C36 dicarboxylic acid or diol.

4. Curable inkjet composition according to any of claims 1 to 3, wherein the polyester has a molecular weight (number average) of more than 1000 g/mol, determined by end group analysis.

5. Curable inkjet composition according to any of claims 1 to 4, wherein the polyester is a linear polyester having an end group functionality of 2.

6. Curable inkjet composition according to any of claims 1 to 5, wherein the polyester is a polyester polyol.

7. Curable inkjet composition according to any of claims 1 to 6, wherein the polyester comprises at least one UV-polymerizable group.

8. Curable inkjet composition according to any of claims 1 to 7, wherein one or more photopolymerizable compounds are a (meth)acrylate comprising a tricyclic aliphatic group.

9. Curable inkjet composition according to any of claims 1 to 8, wherein one or more photopolymerizable compounds are selected from N-vinyl-5-methyl-2-oxazolidinone and/or 4-tert-butylcyclohexylacrylate.

10. Curable inkjet composition according to any of claims 1 to 9, further comprising one or more thermal crosslinker selected from the group consisting of an unblocked isocyanate, a blocked isocyanate and a triazine compound.

11. Curable inkjet composition according to claim 10, wherein the total amount of thermal crosslinkers is more than 5 wt% relative to the total weight of the curable inkjet composition.

12. Curable inkjet composition according to any of claims 1 to 11, having a viscosity of 5 to 15 mPa.s measured a 45°C at a shear rate of 1000 s⁻¹.

13. A method for manufacturing a printed circuit board comprising an inkjet printing step wherein a curable inkjet composition as defined in any of claims 1 to 12 is jetted and cured on a substrate.

14. The method according to claim 13 also comprising a heating step.

15. The method according to claim 13 or 14 wherein the heating step is carried out at a temperature from 80°C to 250°C.

16. The method according to any of claims 13 to 15 wherein the substrate is a dielectric substrate provided with an electrically conductive circuitry.

17. A PCB board comprising a solder mask, wherein the solder mask is obtained using the curable inkjet composition according to any of claims 1 to 12.
